# EUROPEAN PATENT APPLICATION

(11) **EP 3 288 085 A1**
(43) Date of publication of application: **28.02.2018**
(21) Application number: 17185681.8
(22) Date of filing: 10.08.2017
(51) Int. Cl.: H01L 29/66

(54) **SEMICONDUCTOR STRUCTURE AND FABRICATION METHOD THEREOF**

(30) Priority: 23.08.2016 CN 201610711318
(71) Applicant: Semiconductor Manufacturing International Corporation (Shanghai), Shanghai 201203 (CN); Semiconductor Manufacturing International Corporation (Beijing), Beijing 100176 (CN)
(72) Inventor: ZHANG, Chenglong, Shanghai, 201203 (CN); XIAO, Fangyuan, Shanghai, 201203 (CN); WANG, Yan, Shanghai, 201203 (CN)
(74) Representative: Klunker IP Patentanwälte PartG mbB

(57) **Abstract**

A semiconductor structure and a method for fabricating the semiconductor structure are provided. The method includes forming a substrate including a plurality of initial fins, and forming an isolation layer on the substrate between the adjacent initial fins. The method also includes forming a stop layer, and forming a filling opening in the stop layer and forming a trench in the initial fins and the isolation layer. In addition, the method includes forming an isolation structure in the trench and forming a sacrificial layer in the filling opening. Moreover, the method includes removing the stop layer, and back-etching the isolation layer to expose portions of sidewalls of the fins. Further, the method includes forming a gate structure, across a length portion of the fins and covering portions of top surface and sidewalls of each fin, and on the fins, and forming a dummy gate structure on the isolation structure.

## Description

### CROSS-REFERENCES TO RELATED APPLICATIONS

This application claims the priority of Chinese patent application No. 201610711318.X, filed on August 23, 2016.

### FIELD OF THE DISCLOSURE

The present invention generally relates to the field of semiconductor manufacturing and, more particularly, relates to a semiconductor structure and fabrication method thereof.

### BACKGROUND

To overcome the short-channel effect of transistor and suppress the leakage current, fin field effect transistors (FinFET) have been developed with multigate structure. The FinFET includes a fin and an isolation layer formed on the surface of a semiconductor substrate. The isolation layer covers portions of the sidewall of the fin, and the surface of the isolation layer is lower than the top of the fin. The FinFET also includes a gate structure formed on the surface of the isolation layer and on the top and sidewalls of the fin. Further, the FinFET includes a source region and a drain region formed in the fin on both sides of the gate structure.

In addition, to improve the operating speed of a chip and the performance of the transistor, a stress layer is introduced into the source and drain regions of the transistor to increase mobility of carriers in the channel. The source and drain regions made of germanium-silicon material or carbon-silicon material can introduce compressive stress or tensile stress into the channel region of the transistor, thereby improving the performance of the transistor. The stress layer in the FinFET formed by conventional techniques is located in the fin on both sides of the gate structure.

With the reduced size of the semiconductor device as well as the transistor, the distance between adjacent FinFETs also decreases accordingly. The stress layers in adjacent FinFETs are prone to be merged, thereby causing a bridging between the source and drain regions of the adjacent FinFETs. To prevent the bridging between the source and drain regions of the adjacent FinFETs, a single diffusion break (SDB) structure has been developed.

However, the fabrication method of the SDB structure by the conventional techniques is complicated and it is difficult to ensure the performance of the formed single diffusion break structure, thus impacting the performance of the formed semiconductor structure.

### BRIEF SUMMARY OF THE DISCLOSURE

It is an object of the present invention to provide a device structure and method for fabricating the same which may solve one or more problems set forth above and other problems, in particular which method is less complicated, may ensure the desired performance of a formed single diffusion break structure, so that the performance of the formed semiconductor structure can be improved.

The object is achieved by the features of the respective independent claims. Further embodiments are defined in the respective dependent claims

A first aspect of the present invention provides a method for fabricating a semiconductor structure.

The method includes forming a substrate including a plurality of initial fins parallel to each other, and forming an isolation layer on the substrate between the adjacent initial fins. The method also includes forming a stop layer on the initial fins and the isolation layer, and forming a filling opening in the stop layer and forming a trench in the initial fins and the isolation layer, by etching the stop layer and the initial fins. Extension directions of the trench and the filling opening are perpendicular to a length direction of the initial fin. In addition, the method includes forming an isolation structure in the trench and forming a sacrificial layer in the filling opening by respectively filling the trench and the filling opening with a dielectric material. A top surface of the dielectric material is coplanar with a surface of the stop layer, and the isolation structure divides the initial fins into a plurality of fins arranged along the length direction of the initial fin. Moreover, the method includes removing the stop layer to expose the isolation layer, and back-etching the isolation layer to expose portions of sidewalls of the fins, wherein the sacrificial layer is thinned when back-etching the isolation layer. Further, the method includes forming a gate structure, across a length portion of the fins and covering portions of top surface and sidewalls of each fin, and on the fins, and forming a dummy gate structure on the isolation structure when forming the gate structure.

Preferably, etching the stop layer and the initial fins includes: performing a dry etching process to etch the stop layer and the initial fins to form the filling opening and the trench.

The method according to claim 1, after forming the stop layer and before etching the stop layer and the initial fins, further including: forming a stacked mask layer having an etching opening on the stop layer.

Preferably, after etching the stop layer and the initial fins and before filling the filling opening and the trench with the dielectric material, further including: removing the stacked mask layer to expose the stop layer.

Preferably, when forming the stop layer, the stop layer is a silicon nitride layer.

Preferably, forming the stacked mask layer includes: forming a filling layer on the stop layer; forming a mask layer on the filling layer; forming a patterned layer on the mask layer; and forming the etching opening in the patterned layer, wherein a bottom of the etching opening exposes the mask layer.

Preferably, the filling layer is an organic dielectric layer, or an advanced patterning film.

Preferably, when the filling layer is the organic dielectric layer, the mask layer is a SiO-based hard mask layer; the patterned layer is a photoresist layer; and the bottom of the etching opening exposes the SiO-based hard mask layer; or, when the filling layer is the advanced patterning film, the mask layer includes a low temperature oxide layer and a bottom anti-reflection layer formed on the low temperature oxide layer; the patterned layer is a photoresist layer; and the bottom of the etching opening exposes the bottom anti-reflection layer.

Preferably, removing the stop layer includes: performing a phosphoric acid etching process to remove the stop layer.

Preferably, when forming the stop layer, the stop layer is an organic dielectric layer, or an advanced patterning film.

Preferably, forming the stacked mask layer includes: forming a mask layer on the stop layer; forming a patterned layer on the mask layer; and forming the etching opening in the patterned layer, wherein a bottom of the etching opening exposes the mask layer.

Preferably, when the stop layer is the organic dielectric layer, the mask layer is a SiO-based hard mask layer; the patterned layer is a photoresist layer; and the bottom of the etching opening exposes the SiO-based hard mask layer; or, when the stop layer is the advanced patterning film, the mask layer includes a low temperature oxide layer and a bottom anti-reflection layer formed on the low temperature oxide layer; the patterned layer is a photoresist layer; and the bottom of the etching opening exposes the bottom anti-reflection layer.

Preferably, removing the stop layer includes: performing a tetramethylammonium hydroxide solution etching process to remove the stop layer.

Preferably, after forming the filling opening and the trench and before filling the filling opening and the trench with the dielectric material, further including: forming a pattern fixed layer covering a bottom and sidewalls of the trench and sidewalls of the filling opening.

Preferably, when forming the pattern fixed layer, the pattern fixed layer is made of oxide.

Preferably, forming the pattern fixed layer includes: performing an atomic layer deposition process to form the pattern fixed layer.

Preferably, when forming the pattern fixed layer, a thickness of the pattern fixed layer is in a range of approximately 100Å - 2000Å.

A second aspect of the present invention provides a semiconductor structure.

The semiconductor structure includes a substrate including a plurality of fins parallel to each other, and an isolation layer on the substrate between the adjacent fins and perpendicular to a length direction of the fin. A top surface of the isolation layer is lower than top surfaces of the fins, and the isolation layer exposes portions of sidewalls of the fins. The semiconductor structure also includes an isolation structure between the adjacent fins arranged along the length direction of the fin. An extension direction of the isolation structure is perpendicular to the length direction of the fin. In addition, the semiconductor structure includes a pattern fixed layer, between the isolation structure and the fins as well as the substrate. Moreover, the semiconductor structure includes a gate structure across a length portion of the fins and covering portions of the top surface and sidewalls of each fin, and on the fins. Further, the semiconductor structure includes a dummy gate structure on the isolation structure.

Preferably, the pattern fixed layer is made of oxide.

Preferably, a thickness of the pattern fixed layer is in a range of approximately 100Å - 2000Å.

A semiconductor structure according to the second aspect of the present invention may be obtained by a method according to the first aspect of the present invention.

Other aspects of the present invention can be understood by those skilled in the art in light of the description, the claims, and the drawings of the present invention.

### BRIEF DESCRIPTION OF THE DRAWINGS

Figures 1-5 illustrate semiconductor structures corresponding to certain stages for forming a semiconductor structure;
Figures 6-13 illustrate semiconductor structures corresponding to certain stages of an exemplary fabrication method to form a semiconductor structure consistent with various disclosed embodiments of the present invention;
Figures 14-19 illustrate semiconductor structures corresponding to certain stages of another exemplary fabrication method to form a semiconductor structure consistent with various disclosed embodiments of the present invention;
Figure 20 illustrates an exemplary fabrication method to form a semiconductor structure consistent with various disclosed embodiments of the present invention; and
Figure 21 illustrates another exemplary fabrication method to form a semiconductor structure consistent with various disclosed embodiments of the present invention.

### DETAILED DESCRIPTION

Reference will now be made in detail to exemplary embodiments of the disclosure, which are illustrated in the accompanying drawings. Wherever possible, the same reference numbers will be used throughout the drawings to refer to the same or the alike parts.

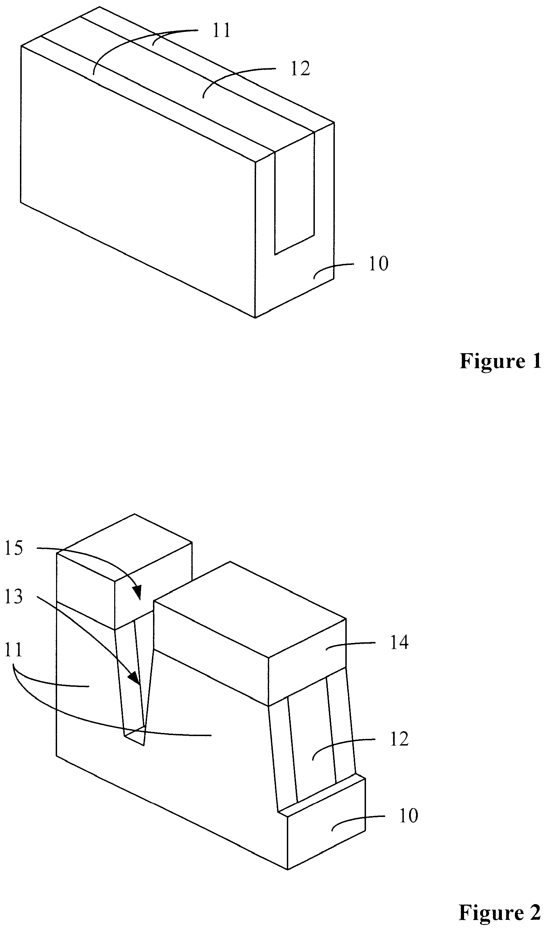

Figures 1-5 illustrate semiconductor structures corresponding to certain stages for forming a semiconductor structure. Referring to Figure 1, a substrate 10 including a plurality of initial fins 11 is formed. An isolation layer 12 is formed between the adjacent fins 11. The top surface of the isolation layer 12 is coplanar with the top surfaces of the initial fins 11.

Referring to Figure 2, a trench 13 is formed in the initial fins 11 and the isolation layer 12. Forming the trench 13 includes forming a patterned layer 14 on the initial fins 11 and the isolation layer 12. The patterned layer 14 includes a first opening 15, and the first opening 15 is configured to define the size and position of the trench 13. Forming the trench 13 also includes etching the initial fins 11 and the isolation layer 12 with the patterned layer 14 as an etching mask to form the trench 13 in the initial fins 11 and the isolation layer 12.

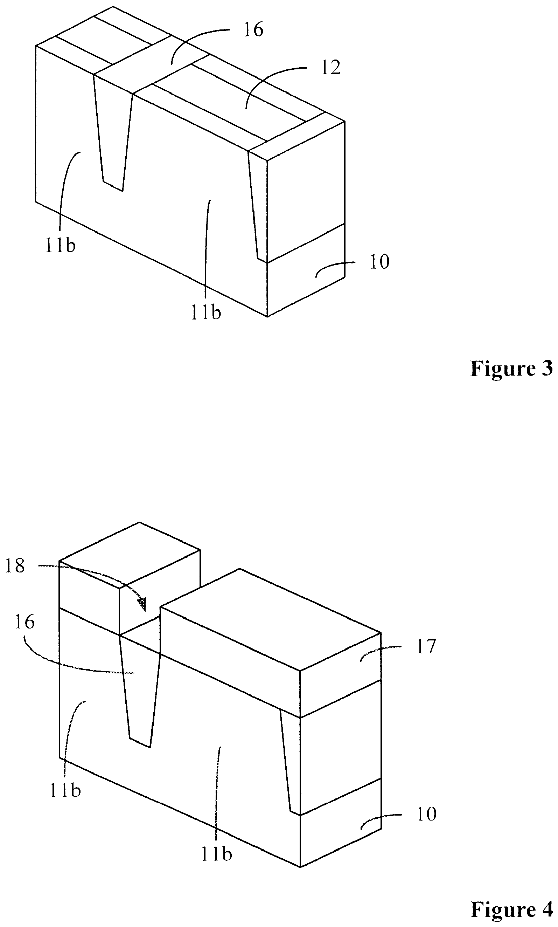

Referring to Figure 3, the trench 13 (shown in Figure 2) is filled with a dielectric material to form an isolation structure 16 in the initial fins 11 (shown in Figure 2). The isolation structure 16 divides each initial fin 11 into two fins 11b arranged along a length direction of the initial fin 11.

Referring to Figure 4, an isolation mask layer 17 is formed on the isolation structure 16, the isolation layer 12, and the fins 11b. The isolation mask layer 17 includes a second opening 18, and the bottom of the second opening 18 exposes the top surface of the isolation structure 16.

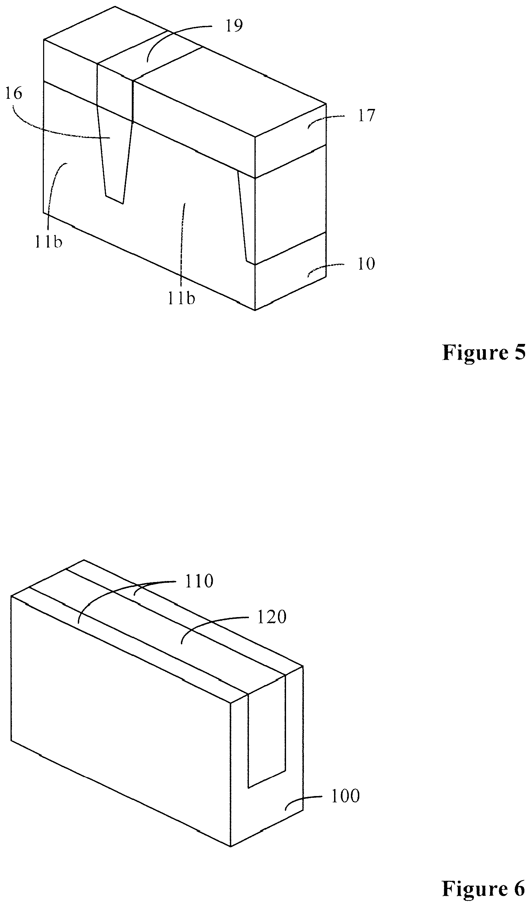

Referring to Figure 5, the second opening 18 (shown in Figure 4) is filled with a dielectric material to form a sacrificial layer 19 in the second opening 18.

The isolation mask layer 17 is subsequently removed to expose the isolation layer 12. The isolation layer 12 is back-etched to expose portions of sidewalls of the fins 11b. The sacrificial layer 19 is thinned when back-etching the isolation layer 12.

When forming the single diffusion break structure by the conventional techniques, the isolation structure 16 is formed by a filling process followed by an etching process, and the sacrificial layer 19 is formed by a filling process followed by an etching process. When forming the isolation structure 16 and the sacrificial layer 19, the etching process for each is performed by using a mask. In other words, the conventional method to form the single diffusion break structure needs to use the mask twice. Using the mask twice not only increases the process cost, but also easily causes an overlay issue. Therefore, the process difficulty of forming the single diffusion break structure increases, and it is difficult to ensure the performance of the formed semiconductor structure.

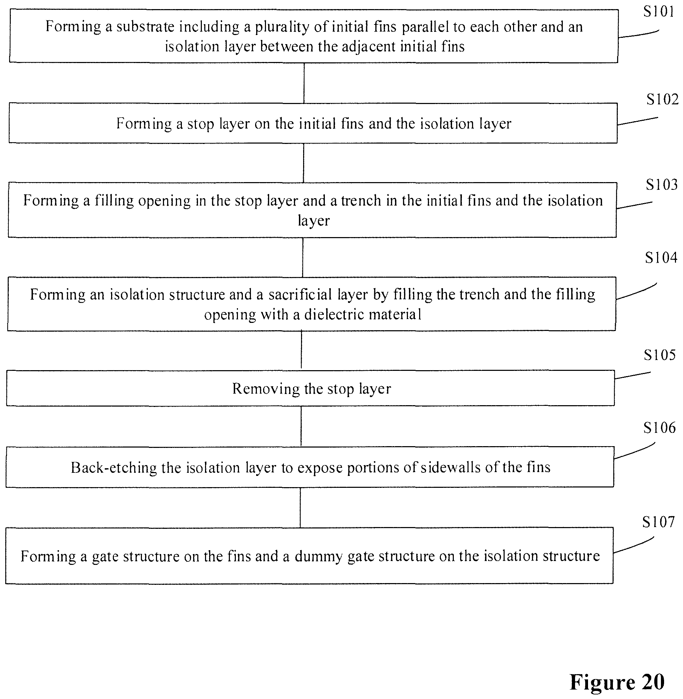

The present invention provides a semiconductor structure and fabrication method thereof. Figure 20 illustrates an exemplary fabrication method to form a semiconductor structure consistent with the disclosed embodiments; and Figures 6-13 illustrate semiconductor structures corresponding to certain stages of the exemplary fabrication process.

As shown in Figure 20, at the beginning of the fabrication process, a substrate with certain structures may be formed (S101). Figure 6 illustrates a corresponding semiconductor structure.

Referring to Figure 6, a substrate 100 including a plurality of initial fins 110 parallel to each other may be formed. The substrate 100 may provide a platform for subsequent fabrication processes to form the semiconductor structure. The initial fins 110 may be used to form fins, so as to form a FinFET.

Forming the substrate 100 and the initial fins 110 may include: providing a base substrate; forming a patterned initial mask layer on the base substrate; and etching the base substrate with the patterned initial mask layer as an etching mask to form the substrate 100 and the initial fins 110.

The base substrate may provide a platform for subsequent fabrication processes, and may be used to be etched to form the initial fins 110. In one embodiment, the base substrate may be a monocrystalline silicon base substrate, thus the substrate 100 and the initial fins 110 may be made of monocrystalline silicon. In certain embodiments, the base substrate may be made of polysilicon, or amorphous silicon. The base substrate may also be made of germanium (Ge), gallium arsenide, or silicon germanium and other semiconductor materials thereof.

In certain embodiments, the base substrate may also include a silicon structure having an epitaxial layer or on an epitaxial layer. For example, the base substrate may include a substrate and a semiconductor layer on the substrate. The semiconductor layer may be formed on the substrate by a selective epitaxial deposition process. The substrate may include a silicon substrate, a germanium silicon substrate, a silicon carbide substrate, a silicon on insulator (SOI) substrate, a germanium on insulator (GOI) substrate, a glass substrate, or Group III-V compounds substrates, such as a gallium arsenide (GaAs) substrate, or a gallium nitride (GaN) substrate, etc. The semiconductor layer may be made of silicon, germanium, silicon carbide, or germanium silicon, etc. The materials of forming the substrate and the semiconductor layer are not limited. The substrate may be made of materials adapted to process requirements and easy integration, and the semiconductor layer may be made of materials adapted to forming the fin. The thickness of the semiconductor layer can be controlled by the epitaxial process, thus the height of the initial fin 110 can be precisely controlled.

The patterned initial mask layer may be used to define the position and size of the initial fins 110. Forming the patterned initial mask layer may include: forming an initial mask material layer on the base substrate; forming a patterned layer on the initial mask material layer; and etching the initial mask material layer with the patterned layer as an etching mask until the surface of the base substrate is exposed to form the patterned initial mask layer. In one embodiment, the initial mask layer may be made of silicon nitride.

In one embodiment, before forming the patterned initial mask layer, a buffer layer (not labeled) may be formed on the base substrate to improve the lattice mismatch problem between the initial mask layer and the base substrate. In one embodiment, the buffer layer may be made of oxide.

In one embodiment, the patterned layer may be a patterned photoresist layer formed by a coating process and a photolithography process. In addition, to reduce feature dimensions of the initial fins and distance between the adjacent fins, so as to further improve the integration degree of the formed semiconductor structure, the patterned layer may be formed by a multiple patterned mask process. The multiple patterned mask process may include a self-aligned double patterned (SaDP) process, a self-aligned triple patterned (SaTP) process, or a self-aligned double double patterned (SaDDP) process, etc.

Referring to Figure 6, an isolation layer 120 may be formed between the adjacent fins 110. The isolation layer 120 may be used to electrically isolate the adjacent fins. The isolation layer 120 may be made of silicon oxide, silicon nitride, silicon oxynitride, low-K dielectric materials (dielectric constant is greater than or equal to 2.5 and is less than 3.9, such as porous silicon oxide, or porous silicon nitride), or ultra-low-K dielectric materials (dielectric constant is less than 2.5, such as porous SiCOH), etc.

Forming the isolation layer 120 may include forming an isolation material layer to fill the space between the adjacent fins 110. The top surface of the isolation material layer may be above the top surfaces of the initial fins 110. Forming the isolation layer 120 may also include planarizing the isolation material layer until the top surfaces of the initial fins 110 are exposed.

As the density of the semiconductor structure increases, the size of the space between the adjacent fins reduces accordingly, thus the depth-to-width ratio of the trench between the adjacent fins increases. To ensure that the isolation material layer can completely fill the trench between the adjacent fins, a flowable chemical vapor deposition (FCVD) process may be performed to form the isolation material layer.

When planarizing the isolation material layer, the planarization treatment may include a chemical mechanical polishing process. In one embodiment, the planarization treatment may also remove the initial mask layer formed on the initial fins 110 to expose the top surfaces of the initial fins 110.

In one embodiment, to repair the damages or roughness on the surfaces of the substrate 100 and the initial fins 110, and to improve the performance of the semiconductor structure, after forming the substrate 100 and the initial fins 110 and before forming the isolation layer 120, a liner oxide layer (not labeled) may be formed on the surfaces of the substrate 100 and the initial fins 110. The liner oxide layer may smooth the sharp corners on the surfaces of the substrate 100 and the initial fins 110, and act as a buffer layer between the subsequently formed film layer and the substrate 100 and the initial fins 110 to reduce the lattice mismatch thereof. The liner oxide layer may be formed by a chemical vapor deposition process, or a thermal oxidation process, etc. In certain embodiments, the damages may be repaired by performing an annealing process on the substrate 100 and the fins 110.

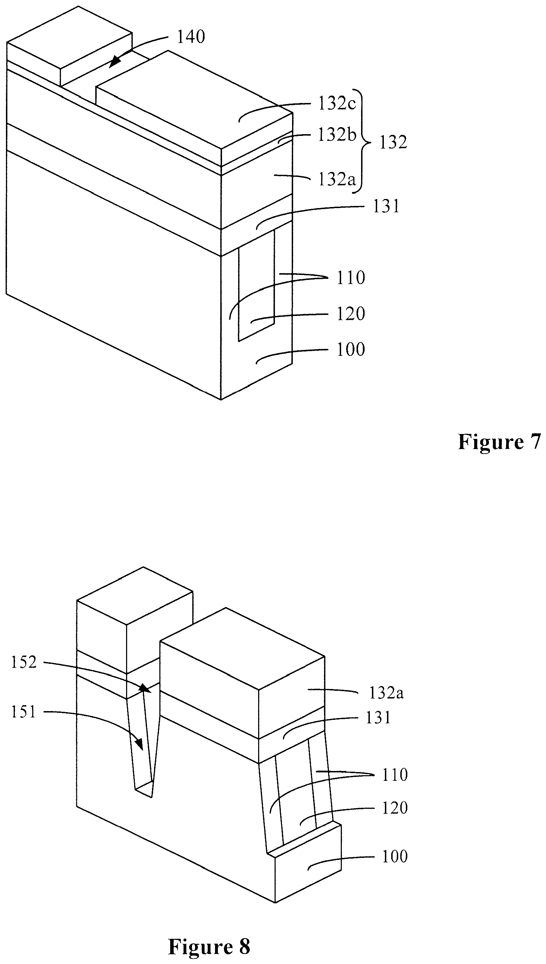

Returning to Figure 20, after forming the substrate having the initial fins and the isolation layer, a stop layer may be formed (S102). Figure 7 illustrates a corresponding semiconductor structure.

Referring to Figure 7, a stop layer 131 may be formed on the initial fins 110 and the isolation layer 120. The stop layer 131 may be used to stop a subsequent planarization process. The stop layer 131 may also provide a process space for subsequently forming a sacrificial layer.

In one embodiment, the stop layer 131 may be made of silicon nitride. The stop layer 131 may be formed by a chemical vapor deposition process, a physical vapor deposition process, an atomic layer deposition process, or other film deposition processes. In addition, the stop layer 131 may also be used to define the thickness of the subsequently formed sacrificial layer. Therefore, the thickness of the stop layer 131 may be in a range of approximately 100Å - 2000Å.

Returning to Figure 20, after forming the stop layer, a filling opening and a trench may be formed (S103). Figures 7-9 illustrate corresponding semiconductor structures.

Referring to Figures 7-9, a filling opening 152 in the stop layer 131 and a trench 151 in the initial fins 110 and the isolation layer 120 may be formed by etching the stop layer 131, the initial fins 110, and the isolation layer 120. The extension direction of the trench 151 and the filling opening 152 may be perpendicular to the length direction of the initial fins 110.

The filling opening 152 and the trench 151 formed by etching the stop layer 131, the initial fins 110, and the isolation layer 120 may provide process spaces for subsequently forming the sacrificial layer and an isolation structure. In one embodiment, etching the , the initial fins 110, and the isolation layer 120 may include performing a dry etching process to etch the stop layer 131, the initial fins 110, and the isolation layer 120 to form the filling opening 152 and the trench 151.

Referring to Figure 7, after forming the stop layer 131 and before etching the stop layer 131, the initial fins 110, and the isolation layer 120, a stacked mask layer 132 having an etching opening 140 may be formed on the stop layer 131.

The stacked mask layer 132 may be used as an etching mask when etching the stop layer 131 and the initial fins 110 to protect the stop layer from being etched. The etching opening 140 may be used to define the positions of the subsequently formed filling opening and trench.

In one embodiment, forming the stacked mask layer 132 may include: forming a filling layer 132a on the stop layer 131; forming a mask layer 132b on the filling layer 132a; forming a patterned layer 132c on the mask layer 132b; and forming the etching opening 140 in the patterned layer 132c. The bottom of the etching opening 140 may expose the mask layer 132b.

The filling layer 132a may be used to fill the roughness of the surface of the stop layer 131. In one embodiment, the filling layer 132a may be an organic dielectric layer (ODL). The filling layer 132a may be formed on the stop layer 131 by a spin-on process.

The mask layer 132b may be used as an etching mask to protect the film layer under the mask layer 132b. In one embodiment, the mask layer 132b may be a SiO-based hard mask (SHB) layer. The mask layer 132b may be formed on the filling layer 132a by a chemical vapor deposition process, a physical vapor deposition process, an atomic layer deposition process, or other film deposition processes.

The patterned layer 132c may be used to define the size and positions of the subsequently formed isolation structure and sacrificial layer. In one embodiment, the patterned layer 132c may be a photoresist layer. The patterned layer 132c may be formed on the mask layer 132b by a coating process and a photolithography process. The etching opening 140 may be formed in the patterned layer 132c, and the bottom of the etching opening 140 may expose the surface of the SiO-based hard mask layer.

In certain embodiments, the filling layer may also be an advanced patterning film (APF). When the filling layer is the advanced patterning film, the mask layer may include a low temperature oxide layer and a bottom anti-reflection layer formed on the low temperature oxide layer; and the patterned layer may be a photoresist layer. The bottom of the etching opening may expose the bottom anti-reflection layer.

Referring to Figure 8, after forming the stacked mask layer 132, the stacked mask layer 132 may be used as an etching mask to sequentially etch the mask layer 132b, the filling layer 132a, the stop layer 131, the initial fins 110, and the isolation layer 120, to form the filling opening 152 in the stop layer 131, and the trench 151 at the bottom of the filling opening 152 and penetrating through the filling opening 152.

In the present invention, by using the stacked mask layer as an etching mask, the filling opening 152 and the trench 151 may be formed by one same, single etching step and using the same mask for one time. Compared to the method of respectively forming the filling opening and the trench by two etching steps, the number of times for using the masks may be reduced, which is beneficial for simplifying the process and reducing the process cost.

Further, the method of forming the filling opening 152 and the trench 151 in the same, single etching step for one time can also avoid the overlay issue when multiple masks are used in conventional etching processes. The disclosed method is beneficial for reducing the process difficulty of forming the isolation structure and the sacrificial layer and improving the performance of the formed semiconductor structure.

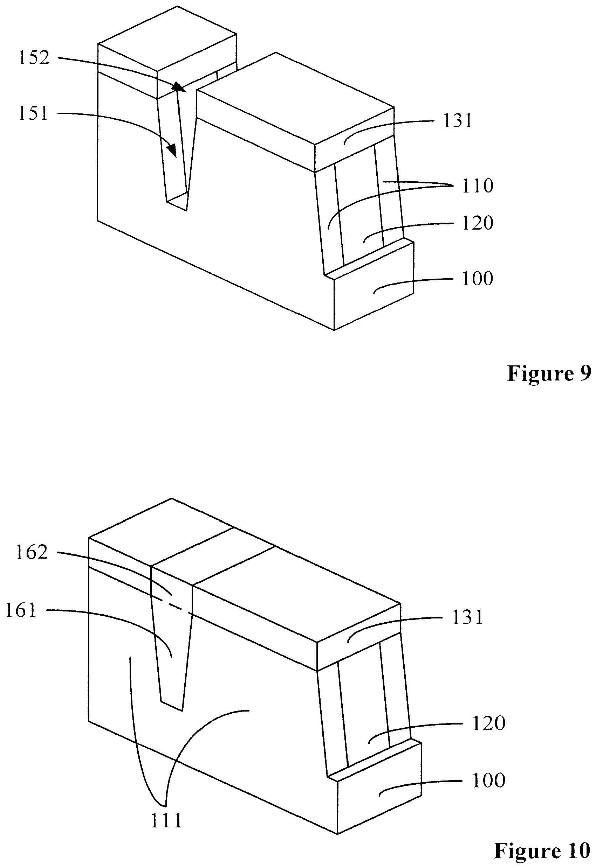

Referring to Figure 9, in one embodiment, after forming the filling opening 152 and the trench 151 by etching the stop layer 131, the initial fins 110, and the isolation layer 120, the stacked mask layer 132 (shown in Figure 7) may be removed to expose the stop layer 131. In one embodiment, when the filling layer 132a is the organic dielectric layer, a tetramethylammonium hydroxide solution etching process may be performed to remove the stacked mask layer 132.

Returning to Figure 20, after forming the filling opening and the trench, an isolation structure and a sacrificial layer may be formed (S104). Figure 10 illustrates a corresponding semiconductor structure.

Referring to Figure 10, the trench 151 (shown in Figure 9) and the filling opening 152 (shown in Figure 9) may be filled with a dielectric material. The top surface of the dielectric material may be coplanar with the surface of the stop layer 131. An isolation structure 161 may include the dielectric material filled in the trench 151, and a sacrificial layer 162 may include the dielectric material filled in the filling opening 152. The isolation structure 161 may divide the initial fins 110 into a plurality of fins 111 arranged along the length direction of the initial fins 110.

The isolation structure 161 may be used to electrically isolate the adjacent fins 111 arranged along the length direction of the initial fins 110. The sacrificial layer 162 may be used to protect the isolation structure 161 when subsequently back-etching the isolation layer 120 to expose portions of sidewalls of the fins 111.

In one embodiment, the dielectric material may be silicon oxide. In certain embodiments, the dielectric material may be silicon nitride, silicon oxynitride, low-K dielectric materials (dielectric constant is greater than or equal to 2.5 and is less than 3.9), or ultra-low-K dielectric materials (dielectric constant is less than 2.5), etc.

Forming the isolation structure 161 and the sacrificial layer 162 may include forming a dielectric material layer by filling the trench 151 and the filling opening 152 with the dielectric material. The top surface of the dielectric material layer may be above the top surface of the stop layer 131. Forming the isolation structure 161 and the sacrificial layer 162 may also include planarizing the dielectric material layer until the stop layer 131 is exposed, thus the top surface of the sacrificial layer 162 may be coplanar with the top surface of the stop layer 131.

In one embodiment, the dielectric material layer may be formed by a chemical vapor deposition process, a physical vapor deposition process, an atomic layer deposition process, or other film deposition processes. As the device density increases, the distance between the adjacent fins 111 may decrease accordingly, thus the depth-to-width ratios of the trench 151 and the filling opening 152 may increase. To ensure that the dielectric material can sufficiently fill the trench 151 and the filling opening 152, in certain embodiments, a flowable chemical vapor deposition (FCVD) process may be performed to form the dielectric material layer. A chemical mechanical polishing process may be used to perform the planarization process on the dielectric material layer.

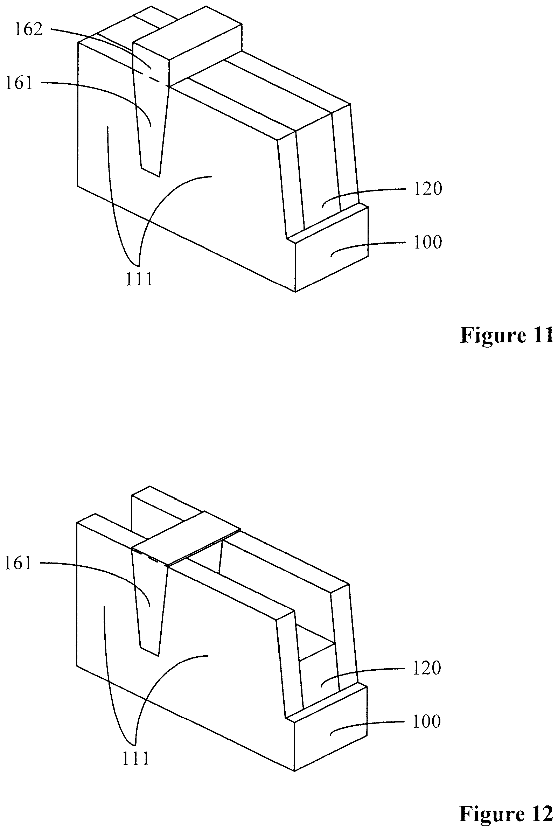

Returning to Figure 20, after forming the isolation structure and the sacrificial layer, the stop layer may be removed (S105). Figure 11 illustrates a corresponding semiconductor structure.

Referring to Figure 11, the stop layer 131 may be removed to expose the isolation layer 120. The process of removing the stop layer 131 to expose the top surface of the isolation layer 120 may provide a process surface for back-etching the isolation layer 120. In one embodiment, because the stop layer 131 is a silicon nitride layer, a phosphoric acid etching process may be performed to remove the stop layer 131.

Because the stop layer 131 may also cover the top surfaces of the fins 111, the top surfaces of the fins 111 may also be exposed while removing the stop layer 131 to expose the top surface of the isolation layer 120.

Returning to Figure 20, after removing the stop layer, the isolation layer may be back-etched (S106). Figure 12 illustrates a corresponding semiconductor structure.

Referring to Figure 12, the isolation layer 120 may be back-etched to expose portions of sidewalls of the fins 111. The sacrificial layer 162 (shown in Figure 11) may be thinned when back-etching the isolation layer 120.

In one embodiment, because the semiconductor structure is a FinFET, back-etching the isolation layer 120 may be used to remove portions of thickness of the isolation layer 120 to expose portions of sidewalls of the fins 111. Thus, the subsequently formed gate structure may cover portions of sidewalls of the fins 111.

In one embodiment, a fluorine-containing gas may be used to back-etch the isolation layer 120. In one embodiment, the fluorine-containing gas may include C₄F₆ gas, or C₄F₈ gas, etc.

Because the surface of the sacrificial layer 162 (shown in Figure 11) is exposed, the sacrificial layer 162 may be thinned when back-etching the isolation layer 120. Because of the thinning of the sacrificial layer 162, the isolation structure 161 may be prevented from being lost when back-etching the isolation layer 120, so as to protect the isolation structure 161.

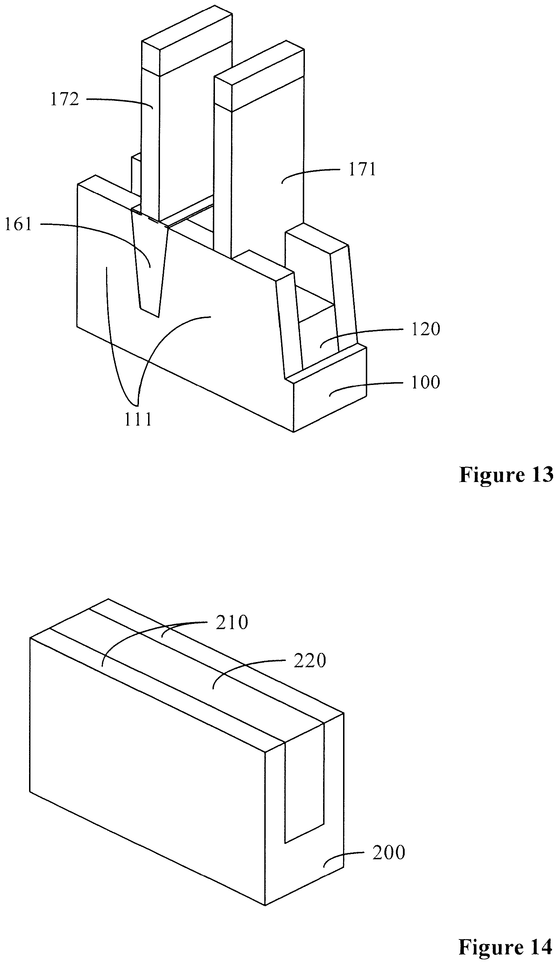

Returning to Figure 20, after back-etching the isolation layer, a gate structure and a dummy gate structure may be formed (S107). Figure 13 illustrates a corresponding semiconductor structure.

Referring to Figure 13, a gate structure 171 may be formed on the fins 111. The gate structure 171 may be across length portions of the fins 111, and cover portions of the top surface and sidewalls of each fin 111. A dummy gate structure 172 may be formed on the isolation structure 161 when forming the gate structure 171.

In one embodiment, forming the gate structure 171 and the dummy gate structure 172 may include: forming a gate material layer on the fins 111 and on the isolation structure 161; forming a gate patterned layer on the gate material layer, where the gate patterned layer may be used to define the size and positions of the gate structure 171 and the dummy gate structure 172; and etching the gate material layer with the gate patterned layer as an etching mask to form the gate structure 171 and the dummy gate structure 172. The gate structure 171 may be formed on the fins 111, and cover portions of the top surface and sidewalls of each fin 111. The dummy gate structure 172 may be formed on the isolation structure 161.

In one embodiment, the dummy gate structure 172 may be a dummy gate structure 172 in the single diffusion break process, and may be used to achieve isolation between the subsequently formed source region and drain region in the fins 111, so as to avoid the bridging issue between the formed source region and drain region.

In one embodiment, after back-etching the isolation layer 120, portions of thickness of the sacrificial layer 162 may be retained on the isolation structure 161. The dummy gate structure 172 may be formed on the remaining sacrificial layer 162 when forming the dummy gate structure 172.

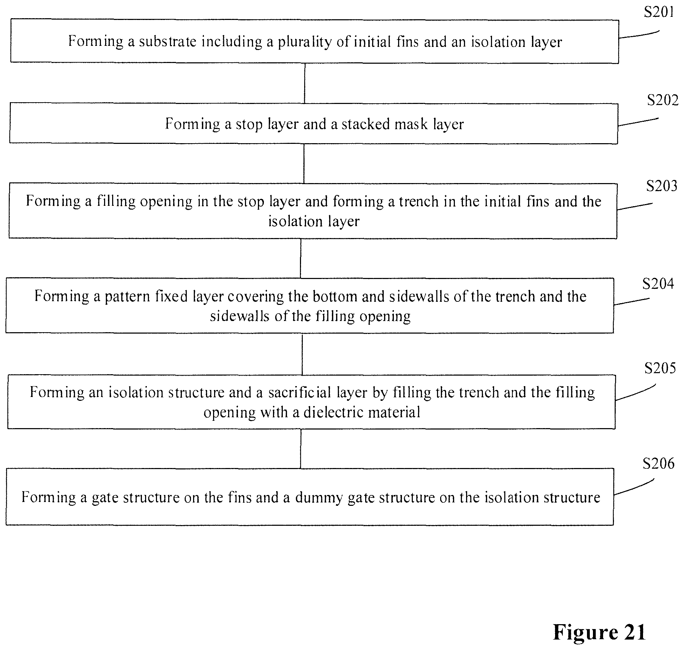

Figure 21 illustrates another exemplary fabrication process to form a semiconductor structure consistent with the disclosed embodiments; and Figures 14-19 illustrate semiconductor structures corresponding to certain stages of the exemplary fabrication process.

As shown in Figure 21, at the beginning of the fabrication process, a substrate having a plurality of initial fins and an isolation layer may be formed (S201). Figure 14 illustrates a corresponding semiconductor structure.

Referring to Figure 14, a substrate 200 including a plurality of initial fins 210 parallel to each other may be formed. An isolation layer 220 may be formed between the adjacent fins 210. Details of the substrate with the initial fins and the isolation layer can be referred to the above descriptions associated with Figure 6, and are not repeated herein.

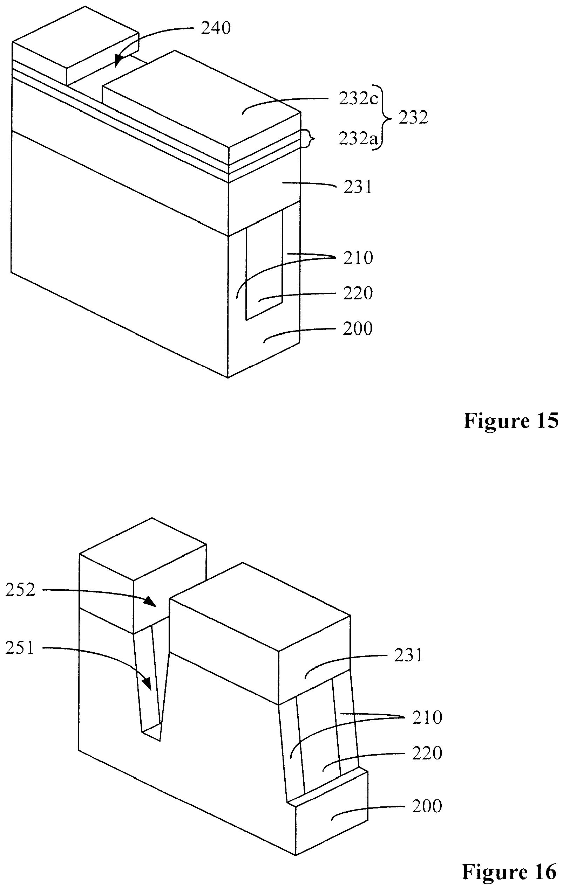

Returning to Figure 21, after forming the substrate with the initial fins and the isolation layer, a stop layer and a stacked mask layer may be formed (S202). Figure 15 illustrates a corresponding semiconductor structure.

Referring to Figure 15, after forming the isolation layer 220, a stop layer 231 may be formed on the initial fins 210 and the isolation layer 220. In one embodiment, the stop layer may be an advanced patterning film. In certain embodiments, the stop layer may be an organic dielectric layer.

In one embodiment, when forming the stop layer 231, the stop layer 231 may be the organic dielectric layer or the advanced patterning film. The method of forming the stop layer 231 by directly using the organic dielectric layer or the advanced patterning film may simplify the process steps and improve the process efficiency.

Referring to Figure 15, after forming the stop layer 231, a stacked mask layer 232 may be formed on the stop layer 231. In one embodiment, forming the stacked mask layer 232 may include: forming a mask layer 232a on the stop layer 231; forming a patterned layer 232c on the mask layer 232a; and forming an etching opening 240 in the patterned layer 232c. The bottom of the etching opening 240 may expose the mask layer 232a.

In one embodiment, the stop layer may be the advanced patterning film. The mask layer 232a may include a low temperature oxide layer and a bottom anti-reflection layer formed on the low-temperature oxide layer. The patterned layer 232c may be a photoresist layer. The bottom of the etching opening may expose the bottom anti-reflection layer.

In certain embodiments, the stop layer may be the organic dielectric layer. When the stop layer is the organic dielectric layer, the mask layer may be a SiO-based hard mask layer; the patterned layer may be a photoresist layer; and the bottom of the etching opening may expose the surface of the SiO-based hard mask layer.

Returning to Figure 21, after forming the stop layer, a filling opening and a trench may be formed (S203). Figure 16 illustrates a corresponding semiconductor structure.

Referring to Figure 16, the stop layer 231 and the initial fins 210 may be etched to form a filling opening 252 in the stop layer 231, and a trench 251 in the initial fins 210 and the isolation layer 220. The extension directions of the trench 251 and the filling opening 252 may be perpendicular to the length direction of the initial fin 210.

In one embodiment, the trench 251 and the filling opening 252 may be formed by sequentially etching the mask layer 232a, the stop layer 231, the initial fins 210, and the isolation layer 220 through the etching opening 240 (shown in Figure 15).

Referring to Figure 16, after forming the filling opening 252 and the trench 251, the remaining stacked mask layer 232 may be removed to expose the stop layer 231.

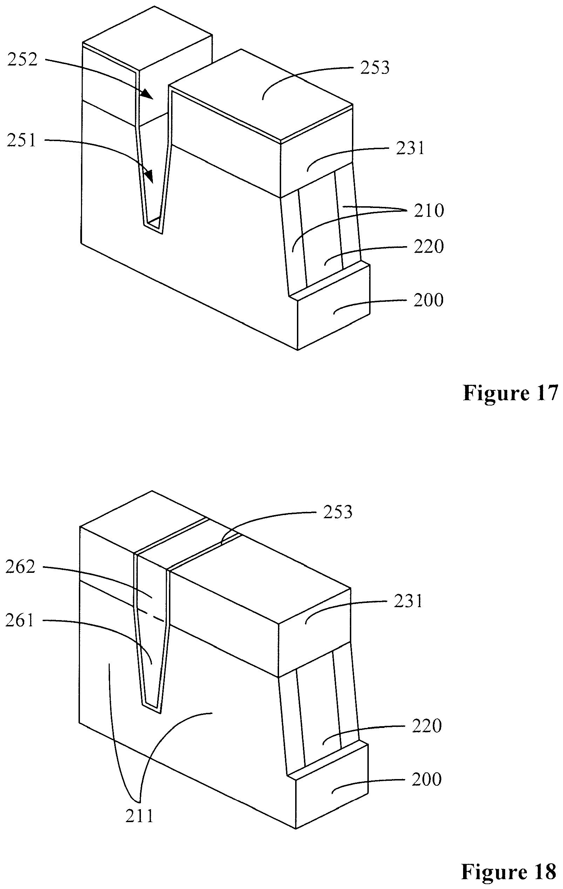

Returning to Figure 21, after forming the filling opening and the trench, a pattern fixed layer may be formed (S204). Figure 17 illustrates a corresponding semiconductor structure.

Referring to Figure 17, because the stop layer 231 is the advanced patterning film or the organic dielectric layer, the material is soft and easily deformed in subsequent processes, thus a pattern fixed layer 253 may be formed after forming the filling opening 252 and the trench 251. The pattern fixed layer 253 may cover the bottom and sidewalls of the trench 251 and the sidewalls of the filling opening 252. The pattern fixed layer 253 may be used to fix the pattern shape of the trench 251 and the filling opening 252, thus the possibility of occurrence of the deformation of the stacked mask layer may be reduced.

In one embodiment, the pattern fixed layer 253 may be made of oxide. The pattern fixed layer 253 may be formed by an atomic layer deposition process. The method of forming the pattern fixed layer 253 by the atomic layer deposition process may improve the step coverage performance of the pattern fixed layer 253 and the accuracy of the pattern fixing of the pattern fixed layer 253 to the trench 251 and the filling opening 252.

If the thickness of the pattern fixed layer 253 is too small, it is difficult to fix the pattern shape of the trench 251 and the filling opening 252. If the thickness of the pattern fixed layer 253 is too large, materials may be wasted and the process difficulty may be increased. In one embodiment, the thickness of the pattern fixed layer 253 may be in a range of approximately 100Å - 2000Å.

In one embodiment, the pattern fixed layer 253 may also cover the surface of the remaining stacked mask layer 232. For example, the pattern fixed layer 253 may cover the top surface of the mask layer 232a.

Returning to Figure 21, after forming the pattern fixed layer, an isolation structure and a sacrificial layer may be formed (S205). Figure 18 illustrates a corresponding semiconductor structure.

Referring to Figure 18, the trench 251 and the filling opening 252 may be filled with dielectric material to form an isolation structure 261 in the trench 251 (shown in Figure 17) and a sacrificial layer 262 in the filling opening 252 (shown in Figure 17). The isolation structure 261 may divide the initial fins 210 into a plurality of fins 211 arranged along the length direction of the initial fins 210.

When filling the dielectric material, the dielectric material may also cover the top surface of the stop layer 231. After filling the trench 251 and the filling opening 252 with the dielectric material, the dielectric material may be planarized until the top surfaces of the remaining pattern fixed layer 253 and the remaining sacrificial layer 262 are coplanar with the top surface of the stop layer 231.

In one embodiment, a chemical mechanical polishing process may be used in the planarization treatment to remove portions of thickness of the dielectric material and the pattern fixed layer 253 to expose the top surface of the stop layer 231.

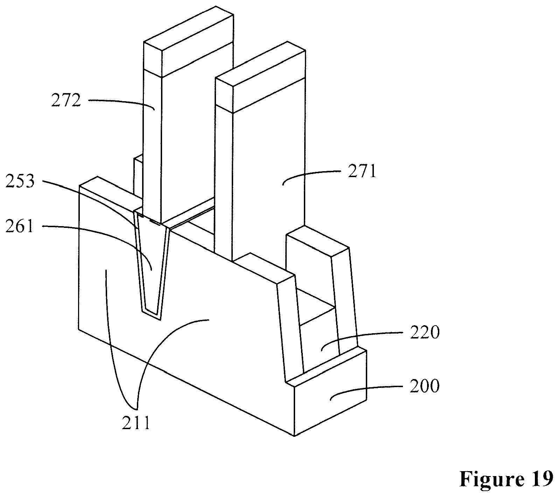

Returning to Figure 21, after forming the isolation structure and the sacrificial layer, a gate structure and a dummy gate structure may be formed (S206). Figure 19 illustrates a corresponding semiconductor structure.

Referring to Figure 19, after forming the isolation structure 261 and the sacrificial layer 262, the stop layer 231 (shown in Figure 18) may be removed to expose the surface of the isolation layer 220.

In one embodiment, the stop layer 231 may be the advanced patterning film. A phosphoric acid etching process may be performed to remove the stop layer 231. In certain embodiments, the stop layer is the organic dielectric layer, a tetramethylammonium hydroxide solution etching process may be performed to remove the stop layer 231.

Referring to Figure 19, after removing the stop layer 231, the isolation layer 220 may be back-etched to expose portions of sidewalls of the fins 211. The sacrificial layer 262 (shown in Figure 18) may be thinned when back-etching the isolation layer 220. Then, a gate structure 271 may be formed on the fins 211. The gate structure 271 may be across length portions of the fins 211, and may cover portions of the top surface and sidewalls of each fin 211. A dummy gate structure 272 may be formed on the isolation structure 261 when forming the gate structure 271. The steps of back-etching the isolation layer 220 and forming the gate structure 271 and the dummy gate structure 272 can be referred to the above-described embodiment, and are not repeated herein.

Correspondingly, a semiconductor structure is provided. Figure 19 illustrates a semiconductor structure consistent with the disclosed embodiments.

Referring to Figure 19, the semiconductor structure may include a substrate 200 having a plurality of fins 211 parallel to each other and an isolation layer 220 formed on the substrate 200 between the adjacent fins 211 and perpendicular to a length direction of the fins 211. The top surface of the isolation layer 220 may be lower than the top surfaces of the fins 211, and the isolation layer 220 may expose portions of sidewalls of the fins 211. The semiconductor structure may also include an isolation structure 261 formed between the adjacent fins 211 arranged along the length direction of the fins 211. The extension direction of the isolation structure 261 may be perpendicular to the length direction of the fins 211. In addition, the semiconductor structure may include a pattern fixed layer 253 formed between the isolation structure 261 and the fins 211 as well as the substrate 200. Moreover, the semiconductor structure may include a gate structure 271 formed on the fins 211. The gate structure 271 may be across length portions of the fins 211, and may cover portions of top surface and sidewalls of each fin 211. Further, the semiconductor structure may include a dummy gate structure 272 formed on the isolation structure 261.

The semiconductor substrate 200 may provide a platform for subsequent fabrication processes to form the semiconductor structure. In one embodiment, the formed semiconductor structure may be a FinFET. Therefore, the plurality of fins 211 parallel to each other may be formed on the substrate 200.

In one embodiment, the substrate 200 and the fins 211 may be made of the same material. In one embodiment, the substrate 200 and the fins 211 may be made of monocrystalline silicon. In certain embodiments, the substrate 200 and the fins 211 may be made of polysilicon, or amorphous silicon. The substrate 200 and the fins 211 may also be made of germanium (Ge), gallium arsenide, or silicon germanium and other semiconductor materials thereof.

In certain other embodiments, the substrate and the fins may be made of different materials. The substrate may include a silicon substrate, a germanium silicon substrate, a silicon carbide substrate, a silicon on insulator (SOI) substrate, a germanium on insulator (GOI) substrate, a glass substrate, or Group III-V compounds substrates, such as a gallium arsenide (GaAs) substrate and a gallium nitride (GaN) substrate, etc. The fin may be made of silicon, germanium, silicon carbide, or germanium silicon, etc. The substrate may be made of materials adapted to process requirements and easy integration, and the semiconductor layer may be made of materials adapted to forming the fin.

The isolation layer 220 may be used to electrically isolate the adjacent fins parallel to each other. In one embodiment, the isolation layer 220 may be made of silicon oxide, silicon nitride, silicon oxynitride, low-K dielectric materials (dielectric constant is greater than or equal to 2.5 and is less than 3.9, such as porous silicon oxide, or porous silicon nitride), or ultra-low-K dielectric materials (dielectric constant is less than 2.5, such as porous SiCOH), etc.

The isolation structure 261 may be used to electrically isolate the adjacent fins arranged along the length direction of the fins. In one embodiment, the structure 261 may be made of silicon oxide, silicon nitride, silicon oxynitride, low-K dielectric materials (dielectric constant is greater than or equal to 2.5 and is less than 3.9), or ultra-low-K dielectric materials (dielectric constant is less than 2.5), etc.

The pattern fixed layer 253 may be used to fix the pattern shape of a trench (not labeled) for forming the isolation structure 261 when forming the isolation structure 261. In one embodiment, the pattern fixed layer 253 may be made of oxide, and may be formed by an atomic layer deposition process.

If the thickness of the pattern fixed layer 253 is too small, it is difficult to fix the pattern shape of the trench. If the thickness of the pattern fixed layer 253 is too large, materials may be wasted and the process difficulty may be increased. In one embodiment, the thickness of the pattern fixed layer 253 may be in a range of approximately 100Å - 2000Å.

In one embodiment, the dummy gate structure 272 may be a dummy gate structure 272 in the single diffusion break process. The dummy gate structure 272 may be used to achieve isolation between the subsequently formed source region and drain region in the adjacent fins 211 arranged along the length direction of the fins 211, so as to avoid the bridging issue between the formed source region and drain region.

In one embodiment, after back-etching the isolation layer 220, portions of thickness of a sacrificial layer (not labeled) may be retained on the isolation structure 261. The dummy gate structure 272 may be formed on the remaining sacrificial layer when forming the dummy gate structure 272.

Accordingly, after forming the stop layer, the filling opening in the stop layer and the trench in the initial fins may be formed by etching the stop layer and the initial fins. The isolation structure and the sacrificial layer may be formed by filling the filling opening and the trench with the dielectric material. In the present invention, the filling opening and the trench may be formed by one same, single etching step and using the same mask for one time. The number of times for using the masks may be reduced, which is beneficial for simplifying the process and reducing the process cost. Further, the method of forming the filling opening and the trench in the same, single etching step for one time can also avoid the overlay issue when multiple masks are used in conventional etching processes. The disclosed method is beneficial for reducing the process difficulty of forming the isolation structure and the sacrificial layer, and improving the performance of the formed semiconductor structure.

In one embodiment, the disclosed method can be used to form FinFET devices having a critical dimension reduced to about 14 nm.

## Claims

1. A method for fabricating a semiconductor structure, comprising:
forming a substrate including a plurality of initial fins parallel to each other;
forming an isolation layer on the substrate between the adjacent initial fins;
forming a stop layer on the initial fins and the isolation layer;
forming a filling opening in the stop layer and forming a trench in the initial fins and the isolation layer, by etching the stop layer and the initial fins, wherein extension directions of the trench and the filling opening are perpendicular to a length direction of the initial fin;
forming an isolation structure in the trench and forming a sacrificial layer in the filling opening by respectively filling the trench and the filling opening with a dielectric material, wherein a top surface of the dielectric material is coplanar with a surface of the stop layer, and the isolation structure divides the initial fins into a plurality of fins arranged along the length direction of the initial fin;
removing the stop layer to expose the isolation layer;
back-etching the isolation layer to expose portions of sidewalls of the fins, wherein the sacriticial layer is thinned when back-etching the isolation layer; and
forming a gate structure, across a length portion of the fins and covering portions of top surface and sidewalls of each fin, and on the fins, and forming a dummy gate structure on the isolation structure when forming the gate structure.

2. The method according to claim 1, wherein etching the stop layer and the initial fins includes:
performing a dry etching process to etch the stop layer and the initial fins to form the filling opening and the trench.

3. The method according to claim 1 or 2, after forming the stop layer and before etching the stop layer and the initial fins, further including:
forming a stacked mask layer having an etching opening on the stop layer.

4. The method according to claim 3, after etching the stop layer and the initial fins and before filling the filling opening and the trench with the dielectric material, further including:
removing the stacked mask layer to expose the stop layer.

5. The method according to claim 3 or 4, wherein:
when forming the stop layer, the stop layer is a silicon nitride layer; and
wherein preferably: removing the stop layer includes: performing a phosphoric acid etching process to remove the stop layer.

6. The method according to claim 5, wherein forming the stacked mask layer includes:
forming a filling layer on the stop layer;
forming a mask layer on the filling layer;
forming a patterned layer on the mask layer; and
forming the etching opening in the patterned layer, wherein a bottom of the etching opening exposes the mask layer.

7. The method according to claim 6, wherein the filling layer is an organic dielectric layer, or an advanced patterning film; and
wherein preferably:
when the filling layer is the organic dielectric layer,
the mask layer is a SiO-based hard mask layer;
the patterned layer is a photoresist layer; and
the bottom of the etching opening exposes the SiO-based hard mask layer; or
when the filling layer is the advanced patterning film,
the mask layer includes a low temperature oxide layer and a bottom anti-reflection layer formed on the low temperature oxide layer;
the patterned layer is a photoresist layer; and
the bottom of the etching opening exposes the bottom anti-reflection layer.

8. The method according to claim 4, wherein:
the stop layer is an organic dielectric layer, or an advanced patterning film.

9. The method according to claim 8, wherein forming the stacked mask layer includes:
forming a mask layer on the stop layer;
forming a patterned layer on the mask layer; and
forming the etching opening in the patterned layer, wherein a bottom of the etching opening exposes the mask layer.

10. The method according to claim 9, wherein:
when the stop layer is the organic dielectric layer,
the mask layer is a SiO-based hard mask layer;
the patterned layer is a photoresist layer; and
the bottom of the etching opening exposes the SiO-based hard mask layer; or
when the stop layer is the advanced patterning film,
the mask layer includes a low temperature oxide layer and a bottom anti-reflection layer formed on the low temperature oxide layer;
the patterned layer is a photoresist layer; and
the bottom of the etching opening exposes the bottom anti-reflection layer.

11. The method according to anyone of the claims 8-10, wherein removing the stop layer includes:
performing a tetramethylammonium hydroxide solution etching process to remove the stop layer.

12. The method according to anyone of the claims 8-11, after forming the filling opening and the trench and before filling the filling opening and the trench with the dielectric material, further including:
forming a pattern fixed layer covering a bottom and sidewalls of the trench and sidewalls of the filling opening.

13. The method according to claim 12, wherein at least one of:
the pattern fixed layer is made of oxide;
forming the pattern fixed layer includes: performing an atomic layer deposition process to form the pattern fixed layer; and
a thickness of the pattern fixed layer is in a range of approximately 100Å - 2000Å.

14. A semiconductor structure, comprising:
a substrate, including a plurality of fins parallel to each other;
an isolation layer, on the substrate between the adjacent fins and perpendicular to a length direction of the fin, wherein a top surface of the isolation layer is lower than top surfaces of the fins, and the isolation layer exposes portions of sidewalls of the fins;
an isolation structure, between the adjacent fins arranged along the length direction of the fin, wherein an extension direction of the isolation structure is perpendicular to the length direction of the fin;
a pattern fixed layer, between the isolation structure and the fins as well as the substrate;
a gate structure, across a length portion of the fins and covering portions of the top surface and sidewalls of each fin, and on the fins; and
a dummy gate structure, on the isolation structure.

15. The semiconductor structure according to claim 14, wherein:
the pattern fixed layer is made of oxide; and/or
a thickness of the pattern fixed layer is in a range of approximately 100Å - 2000Å.
